# EUROPEAN PATENT APPLICATION

(11) **EP 4 369 407 A1**
(43) Date of publication of application: **15.05.2024**
(21) Application number: 22838038.2
(22) Date of filing: 08.07.2022
(51) Int. Cl.: H01L 27/15, H01L 25/075, H01L 33/60, H01L 33/50, H01L 33/62, H01L 33/48, H01L 33/64, H01L 27/12

(54) **LIGHT-EMITTING DEVICE AND LIGHT-EMITTING MODULE COMPRISING SAME**

(30) Priority: 09.07.2021 US 202163220201 P; 13.09.2021 US 202163243509 P; 06.07.2022 US 202217858514
(71) Applicant: Seoul Semiconductor Co., Ltd., Gyeonggi-do 15429 (KR)
(72) Inventor: KIM, Hye In, Ansan-si Gyeonggi-do 15429 (KR); SON, Jung Hun, Ansan-si Gyeonggi-do 15429 (KR); NEI, Masami, Ansan-si Gyeonggi-do 15429 (KR)
(74) Representative: Stolmár & Partner Patentanwälte PartG mbB
(86) International application number: PCT/KR2022/009916
(87) International publication number: WO 2023/282686

(57) **Abstract**

A light-emitting module according to an embodiment of the present invention comprises: light-emitting diode chips mounted on a first surface of a support substrate; a wavelength conversion member formed on the light-emitting surfaces of the light emitting diode chips, and a reflection member formed to surround the side surfaces of the wavelength conversion member; electrode pads formed on a second surface of the support substrate to be respectively electrically connected to the light-emitting diode chips; a circuit board having formed thereon a circuit pattern electrically connected to the electrode pads; and a conductive bonding material formed between the electrode pads and the circuit pattern to electrically connect same, wherein the thermal expansion coefficients of the support substrate, the electrode pads, and the conductive bonding material are different from one another, and the thermal expansion coefficients increase from the support substrate toward the circuit board.

## Description

### [Technical Field]

Embodiments relate to a light emitting device, and more particularly, to a light emitting device in which a light emitting diode chip is mounted and a light emitting module including the same.

### [Background Art]

Recently, various devices which use a light emitting diode (LED) chip as a light source have been developed. A light emitting diode is a semiconductor element which emits light generated through recombination of electrons and holes, and is used in various fields including displays, vehicle lamps, general lighting and the like because of long lifespan, low power consumption and rapid response.

A conventional light emitting device is configured to include at least one light emitting diode chip which is formed on a first surface of a support substrate, a wavelength conversion member which is formed on a light emitting surface of the light emitting diode chip, and an electrode pad which is formed on a second surface of the support substrate and is electrically connected with the electrode of the light emitting diode chip.

As the light emitting device is mounted on a circuit board, a light emitting module which emits one or more light may be implemented. When the light emitting device is mounted on the circuit board, the electrode pad which is formed on the second surface of the support substrate and a circuit pattern which is formed on a first surface of the circuit board should be electrically connected. To this end, a conductive bonding material is formed between the electrode pad and the circuit pattern.

In the case where the light emitting module is implemented as the light emitting device is mounted on the circuit board, when the light emitting module is driven, significant heat is generated in a plurality of light emitting diode chips which are formed in the light emitting device. At this time, a crack may occur in a certain component, for example, the electrode pad or the conductive bonding material, due to differences in coefficients of thermal expansion of components constituting the light emitting module, that is, the support substrate, the electrode pad, the conductive bonding material and the circuit board. Such a crack may serve as a cause for a poor contact between the light emitting device and the circuit board.

### [Detailed Description]

### [Technical Problem]

Various embodiments are directed to a light emitting device in which a thermal expansion compensation layer is formed on the lower surface of an electrode pad of the light emitting device, thereby preventing a crack due to differences in coefficient of thermal expansion among the electrode pad, a circuit pattern formed on one surface of a circuit board and a conductive bonding material formed between the electrode pad and the circuit pattern according to heat generation occurring in at least one light emitting diode chip mounted in the light emitting device, and through this, overcoming the problem of a driving failure of the light emitting device, and a light emitting module including the same.

### [Technical Solution]

According to one aspect of the invention, a light emitting device includes: a support substrate; a light emitting diode chip mounted on a first surface of the support substrate; a wavelength conversion member formed on a light emitting surface of the light emitting diode chip, and a reflection member formed to surround a side surface of the wavelength conversion member; an electrode pad formed on a second surface of the support substrate to be electrically connected with the light emitting diode chip; a conductive bonding material formed on one surface of the electrode pad; and a thermal expansion compensation layer formed on one surface of the conductive bonding material, wherein the thermal expansion compensation layer includes a conductive layer and an insulating layer, and at least a portion of the insulating layer is formed between portions of the conductive layer, and wherein a portion of the conductive layer is surrounded by the insulating layer.

The support substrate may be implemented with a ceramic material including AlN, and the reflection member may be implemented with a silicon material having a white color.

The light emitting device may further include: a heat dissipation member formed on the second surface of the support substrate to be spaced apart from the electrode pad by a predetermined distance.

The heat dissipation member may be implemented in an integral plate shape or may be implemented as honeycomb-shaped separate patterns.

The electrode pad may include a pair of first and second electrode pads which are electrically connected with the light emitting diode chip corresponding to the electrode pad.

The first and second electrode pads may be pads of the same polarity, and may be formed on the second surface of the support substrate to be vertically or horizontally symmetrical to each other.

The electrode pad may be implemented in a pattern shape in which a corner portion has a predetermined curvature.

The thermal expansion compensation layer may be formed between the electrode pad and the conductive bonding material; and the thermal expansion compensation layer may include the insulating layer which has at least one via hole, a first conductive layer which is formed on a first surface of the insulating layer and a second conductive layer which is formed on a second surface of the insulating layer, and the first conductive layer and the second conductive layer may be electrically connected through the via hole.

The insulating layer may be implemented with a polyimide material whose coefficient of thermal expansion is relatively small as compared to the electrode pad and conductive bonding material.

The first conductive layer and the second conductive layer may be implemented with the same material as the electrode pad, and may each be implemented in a pattern shape which has the same width and shape as the electrode pad.

The insulating layer may be implemented in a pattern of a shape which protrudes by a predetermined distance out of the first conductive layer and the second conductive layer when viewed on a cross-section.

According to another aspect of the invention, a light emitting module includes: a light emitting diode chip mounted on a first surface of a support substrate; a wavelength conversion member formed on a light emitting surface of the light emitting diode chip, and a reflection member formed to surround a side surface of the wavelength conversion member; an electrode pad formed on a second surface of the support substrate to be electrically connected with the light emitting diode chip; a circuit board formed with a circuit pattern which is electrically connected with the electrode pad; and a conductive bonding material formed between the electrode pad and the circuit pattern to electrically connect the electrode pad and the circuit pattern, wherein coefficients of thermal expansion of the support substrate, the electrode pad and the conductive bonding material are different, and a coefficient of thermal expansion gradually increases from the support substrate to the circuit board.

The support substrate may be implemented with a ceramic material including AlN, and the reflection member may be implemented with a silicon material having a white color.

The electrode pad may include a pair of first and second electrode pads which are electrically connected with the light emitting diode chip corresponding to the electrode pad.

The first and second electrode pads may be pads of the same polarity, and may be formed on the second surface of the support substrate to be vertically or horizontally symmetrical to each other.

The electrode pad may be implemented in a pattern shape in which a corner portion has a predetermined curvature.

A thermal expansion compensation layer may be additionally included between the electrode pad and the conductive bonding material; and the thermal expansion compensation layer may include an insulating layer which has at least one via hole, a first conductive layer which is formed on a first surface of the insulating layer and a second conductive layer which is formed on a second surface of the insulating layer, and the first conductive layer and the second conductive layer may be electrically connected through the via hole.

The insulating layer may be implemented with a polyimide material whose coefficient of thermal expansion is relatively small as compared to the electrode pad and conductive bonding material.

The first conductive layer and the second conductive layer may be implemented with the same material as the electrode pad, and may each be implemented in a pattern shape which has the same width and shape as the electrode pad.

The insulating layer may be implemented in a pattern of a shape which protrudes by a predetermined distance out of the first conductive layer and the second conductive layer when viewed on a cross-section.

### [Advantageous Effects]

According to the embodiments, by forming a thermal expansion compensation layer on the lower surface of an electrode pad of a light emitting device, it is possible to prevent a crack due to differences in coefficient of thermal expansion among the electrode pad, a circuit pattern formed on one surface of a circuit board and a conductive bonding material formed between the electrode pad and the circuit pattern according to heat generation of a light emitting diode chip mounted in the light emitting device, and through this, overcome the problem of a driving failure of the light emitting device.

### [Description of Drawings]

FIG. 1 is a top view of a light emitting device in accordance with an embodiment of the present disclosure.
FIG. 2 is a cross-sectional view of a region II-II' of the light emitting device illustrated in FIG. 1.
FIGS. 3A and 3B are bottom views of the light emitting device illustrated in FIG. 1.
FIG. 4 is a cross-sectional view of a region I-I' of the light emitting device illustrated in FIGS. 1 and 3A and a light emitting module including the same.
FIG. 5 is a top view of a light emitting device in accordance with another embodiment of the present disclosure.
FIG. 6 is a bottom view of the light emitting device illustrated in FIG. 5.
FIG. 7 is a cross-sectional view of a region IV-IV' of the light emitting device illustrated in FIGS. 5 and 6 and a light emitting module including the same.
FIG. 8 is a cross-sectional view of a region III-III' of the light emitting device illustrated in FIGS. 5 and 6 and the light emitting module including the same.
FIG. 9 is an enlarged cross-sectional view of a thermal expansion compensation layer illustrated in FIG. 8.
FIG. 10 is an enlarged top view of an electrode pad illustrated in FIG. 5.

### [Mode for Implementing the Invention]

The content described in the background art is only intended to help understand the background technology of the technical idea of the present invention, and therefore, it cannot be understood as content corresponding to prior art known to those skilled in the art of the present invention.

In the following description, for the purposes of explanation, numerous specific details are set forth in order to provide a thorough understanding of various embodiments or implementations of the invention. It is apparent, however, that various embodiments may be practiced without these specific details or with one or more equivalent arrangements. In other instances, well-known structures and devices are shown in block diagram form in order to avoid unnecessarily obscuring various embodiments.

In the drawings, the size or relative sizes of layers, films, panels, regions, etc. may be exaggerated for clarity. Additionally, like reference numbers refer to like components.

When an element, such as a layer, is referred to as being "connected to," or "coupled to" another element or layer, it may be directly connected to, or coupled to the other element or layer or intervening elements or layers may be present. When, however, an element or layer is referred to as being "directly connected to," or "directly coupled to" another element or layer, there are no intervening elements or layers present. "At least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of devices, elements, regions, layers, and/or sections, these devices, elements, regions, layers, and/or sections should not be limited by these terms. These terms are used to distinguish one device, element, region, layer, and/or section from another one. Thus, a first device, element, region, layer, and/or section discussed below could be termed a second device, element, region, layer, and/or section without departing from the teachings of the disclosure.

Spatially relative terms, such as "beneath," "below," "under," "lower," "above," "upper," "over," "higher," and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. Unless otherwise defined, all terms (including technical and scientific terms) used herein have the same meaning as commonly understood by one of ordinary skill in the art to which this disclosure is a part.

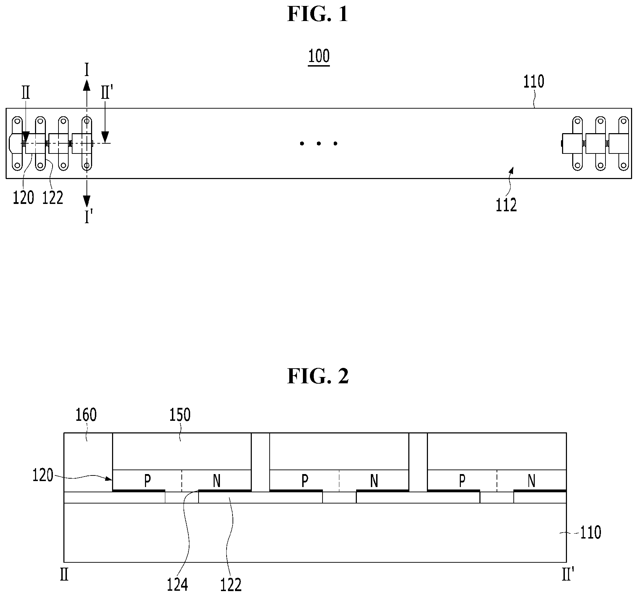

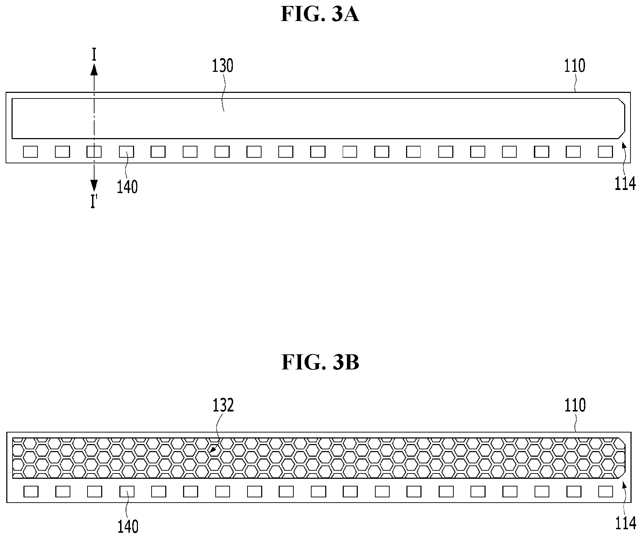

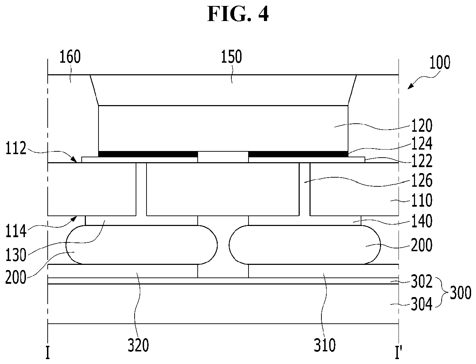

FIG. 1 is a top view of a light emitting device in accordance with an embodiment of the present disclosure, and FIG. 2 is a cross-sectional view of a region II-II' of the light emitting device illustrated in FIG. 1. FIGS. 3a and 3b are bottom views of the light emitting device illustrated in FIG. 1, and FIG. 4 is a cross-sectional view of the light emitting device illustrated in FIGS. 1 and 3a and a light emitting module including the same, illustrating the cross-section of a specified region I-I'.

Referring to FIGS. 1 to 4, a light emitting device 100 in accordance with the embodiment of the present disclosure may include at least one light emitting diode chip 120 which is formed on a first surface 112 of a support substrate 110, a wavelength conversion member 150 which is formed on a light emitting surface of the light emitting diode chip 120, a reflection member 160 which is formed to surround the side surface of the wavelength conversion member 150, at least one electrode pad 140 which is formed on a second surface 114 of the support substrate 110 and is electrically connected with an electrode of the light emitting diode chip 120, and a heat dissipation member 130 or 132 which is formed on the second surface 114 of the support substrate 110 to be spaced apart from the electrode pad 140 by a predetermined distance.

The support substrate 110 may be implemented with a ceramic material including AlN, and due to this fact, the reflection of light generated from the light emitting diode chip 120 is possible, whereby light extraction efficiency may be improved.

In more detail, first, as illustrated in FIGS. 1 and 3, the at least one light emitting diode chip 120, the wavelength conversion member 150 which is formed on the light emitting surface of the light emitting diode chip 120 and the reflection member 160 which is formed to surround the side surface of the wavelength conversion member 150 are formed on the first surface 112 of the support substrate 110. The reflection member 160 may be implemented with, for example, a silicon material having a white color.

The embodiment illustrated in FIG. 1 discloses a structure in which light emitting diode chips 120 are disposed in a line, but this is nothing but a mere example and the light emitting device 100 is not limited thereto. That is to say, the light emitting diode chips 120 may be implemented in a structure in which they are disposed in a plurality of rows.

Referring to FIG. 3, the wavelength conversion member 150 may be formed to cover the light emitting surface of the light emitting diode chip 120. The wavelength conversion member 150 converts the wavelength of light which is emitted from the light emitting diode chip 120, so that white light or light of a specific color is emitted. The wavelength conversion member 150 may be formed as a wavelength conversion material which converts the wavelength of light is mixed to a transparent resin such as silicon or epoxy, glass, ceramic, or the like. For example, the transparent resin may be transparent silicone.

The wavelength conversion material may include a phosphor. For example, as a phosphor emitting light of a green wavelength band, a yttrium aluminum garnet-based phosphor (for example, Y₃(Al, Ga)₅O₁₂:Ce), a lutetium aluminum garnet-based phosphor (for example, Lu₃(Al, Ga)₅O₁₂:Ce), a terbium aluminum garnet-based phosphor (for example, Tb₃(Al, Ga)₅O₁₂:Ce), a silicate-based phosphor (for example, (Ba, Sr)₂SiO₄:Eu), a chlorosilicate-based phosphor (for example, Ca₈Mg(SiO₄)₄Cl₂:Eu), a β-sialon-based phosphor (for example, Si₆-_{z}Al_{z}O_{z}N_{8-z}:Eu (0<z<4.2)), an SGS-based phosphor (for example, SrGa₂S₄:Eu), etc. may be used. As a phosphor emitting light of a yellow wavelength band, an α-sialon-based phosphor (for example, M_{z}(Si, Al)₁₂(O, N)₁₆ (provided that 0<z≤2 and M is a lanthanide except for Li, Mg, Ca, Y, La and Ce), etc. may be used.

Among phosphors emitting light of the green wavelength band, there is also a phosphor emitting light of the yellow wavelength band. In addition, for example, in the yttrium aluminum garnet-based phosphor, by substituting a part of Y with Gd, a light emission peak wavelength may be shifted toward a longer wavelength, and thus, the emission of light of the yellow wavelength band is possible. Moreover, among them, there is also a phosphor capable of emitting light of a main yellow wavelength band.

As a phosphor emitting light of a red wavelength band, a nitrogen-containing calcium aluminosilicon (CASN or SCASN)-based phosphor (for example, (Sr, Ca)AlSiN₃:Eu) may be used. Besides, there is a manganese-activated fluoride-based phosphor (a phosphor expressed by a general formula (I) A₂[M₁₋ₐMnₐF₆]). In the general formula (I), A is at least one selected from the group consisting of K, Li, Na, Rb, Cs and NH₄, M is at least one element selected from the group consisting of group 4 elements and group 14 elements, and a satisfies 0<a<0.2. A representative example of the manganese-activated fluoride-based phosphor is a phosphor of manganese-activated potassium silicon fluoride (for example, K₂SiF₆:Mn). Also, there is a manganese-activated phosphor (a phosphor expressed by a general formula (II) (A₄₋ₐBₐ)_{m/2+n/2}X₂ₘ[MX₄O₂]ₙ) based on an oxiodohalide host lattice. In the general formula (II), A is hydrogen (H) and/or deuterium (D), B is Li, Na, K, Rb, Cs, NH₄, ND₄ and/or NR₄ where R an alkyl or aryl radical, X is F and/or Cl, M is Cr, Mo, W and/or Re, and 0 ≤ a ≤ 4, 0 < m ≤ 10 and 1 ≤ n ≤ 10 are satisfied.

The reflection member 160 may be formed to surround the side surface of the wavelength conversion member 150, and may perform an operation of reflecting light emitted from the light emitting diode chip 120. The reflection member 160 should be formed of a material which reflects light and does not transmit light even though a portion of the light is absorbed. For example, the reflection member 160 may be formed of at least one of silver (Ag) and aluminum (Al). The reflection member 160 formed of silver has a high reflectivity of light. The reflection member 160 formed of aluminum has a high adhesion force with the wavelength conversion member 150. In this way, on the basis of reflectivity or adhesion force, the reflection member 160 may be formed as one layer which is formed of silver or aluminum. Alternatively, the reflection member 160 may be formed in a multi-layered structure in which aluminum, silver and aluminum are stacked, so that both adhesion force and reflectivity are improved. Although not illustrated in the drawings, at least one layer of layers which are formed of nickel (Ni) and titanium (Ti) may be additionally disposed on the reflection member 160. The material of the reflection member 160 is not limited to aluminum and silver, and any material capable of reflecting light emitted from the light emitting diode chip 120 may be used. As described above, the reflection member 160 may be implemented with a silicon material having a white color.

As illustrated in FIGS. 1 and 2, the light emitting diode chip 120 may include a light emitting element which is implemented by a semiconductor PN junction diode, and a predetermined voltage may be applied through an electrode 122 which is attached to the lower surface of the light emitting diode chip 120. In the case of the embodiment illustrated in FIG. 2, light emitting diode chips 120 may be connected in series, and accordingly, each of the plurality of light emitting diode chips 120 may be formed to share the electrode 122 with an adjacent light emitting diode chip 120. For example, referring to FIG. 2, the N electrode of a first light emitting diode chip 120 and the P electrode of a second light emitting diode chip 120 adjacent thereto may be formed to share the pattern of the electrode 122 which is connected thereto, so that the pattern of the electrode 122 is simplified and serial driving is enabled. A conductive adhesive layer 124 may be formed between the light emitting diode chip 120 and the electrode 122. The conductive adhesive layer 124 may be implemented with any one of an anisotropic conductive film (ACF), an anisotropic conductive paste (ACP), a self assembly paste (SAP/epoxy+Sn-Bi), Eutectic, AuSn, AgSn and In.

The principle of the light emitting operation of the light emitting diode chip 120 may be briefly described as follows. After P-type and N-type semiconductors are joined as illustrated, when a predetermined voltage is applied through the electrode 122, the holes of the P-type semiconductor move toward the N-type semiconductor to be collected in a middle layer, and on the contrary, the electrons of the N-type semiconductor move toward the P-type semiconductor to be collected in a middle layer as a lowest place of a conduction band. These electrons spontaneously fall into the holes of a valence band. At this time, energy corresponding to a height difference between the conduction band and the valence band, i.e., an energy gap, is emitted, and this energy is discharged in the form of light. Besides, light emitting diode chips of various light emission types may be used.

As illustrated in FIGS. 3 and 4, on the second surface 114 of the support substrate 110, there may be formed at least one electrode pad 140 which is electrically connected with the electrode of the light emitting diode chip 120 and the heat dissipation member 130 or 132 which is formed on the second surface 114 of the support substrate 110 to be spaced apart from the electrode pad 140 by the predetermined distance.

The heat dissipation member 130 or 132 may be implemented in the shape of an integral plate 130 as illustrated in FIG. 3A or may be implemented as honeycomb-shaped separate patterns 132 as illustrated in FIG. 3B. When the honeycomb-shaped separate patterns 132 are implemented, a surface area may be increased to be more effective in heat dissipation, and since heat dissipation patterns in contact with a conductive bonding material 200 are separated, an effect that a stress by heat is distributed may be achieved. As illustrated in FIG. 4, the heat dissipation member 130 or 132 may be electrically connected with the conductive bonding material 200 and a heat dissipation pattern 320 formed on a circuit board 300 to perform a heat dissipation operation. The heat dissipation pattern 320 may be implemented as a separate pattern which is not electrically connected with a circuit pattern 310 formed on the circuit board 300.

Referring to FIG. 4, as the light emitting device 100 is mounted on the circuit board 300, a light emitting module which emits at least one light may be implemented. The circuit board 300 may be formed by, for example, a conductive substrate 304 which is implemented with aluminum or the like and an insulating buffer layer 302 which is formed on the conductive substrate 304.

In more detail, the electrode 122 which is electrically connected with the light emitting diode chip 120 is brought into electrical contact with the electrode pad 140, which is formed on the second surface 114 of the support substrate 110, through a via hole 126 which is formed in the support substrate 110.

In this case, when the light emitting device 100 is mounted on the circuit board 300, the electrode pad 140 and the circuit pattern 310 formed on a first surface of the circuit board 300 should be electrically connected. To this end, the conductive bonding material 200 is formed between the electrode pad 140 and the circuit pattern 310.

The conductive bonding material 200 may be, for example, one of a solder paste including at least one of Sn, Pb, Cu, Ag, Au, Zn, Al, Bi and In, an Ag paste and an Si paste. In addition to the above-described types of pastes, any conductive material capable of bonding the electrode pad 140 formed on the second surface 114 of the support substrate 110 and the circuit pattern 310 formed on the first surface of the circuit board 300 may be used to form the conductive bonding material 200.

As illustrated in FIG. 4, in the case where the light emitting module is implemented as the light emitting device 100 is mounted on the circuit board 300, when the light emitting module is driven, significant heat is generated in the plurality of light emitting diode chips 120 formed in the light emitting device 100. At this time, a crack may occur in a certain component, for example, the electrode pad 140 or the conductive bonding material 200, due to differences in coefficients of thermal expansion (CTE) of components constituting the light emitting module, that is, the support substrate 110, the electrode pad 140, the conductive bonding material 200 and the circuit board 300. Such a crack may serve as a cause for a poor contact between the light emitting device 100 and the circuit board 300.

In the case of the light emitting device 100 and the light emitting module including the same according to the embodiment of the present disclosure illustrated in FIGS. 1 to 3, in order to minimize the above-described disadvantages, components formed between the support substrate 110 on which the light emitting diode chip 120 is mounted and the circuit board 300 are characterized in that the components are implemented with materials whose coefficients of thermal expansion increase from the support substrate 110 to the circuit board 300.

In other words, heat generation occurs most severely in the light emitting diode chip 120, and in the embodiment of the present disclosure, a component positioned close to the light emitting diode chip 120, that is, the support substrate 110, is implemented with a material whose coefficient of thermal expansion is relatively small, so that thermal expansion occurs less in a region close to the light emitting diode chip 120. In addition, by disposing a material with a large coefficient of thermal expansion as a distance from the support substrate 110 increases, the degrees of expansion according to the degrees of heat absorption of conductive materials positioned between the support substrate 110 and the circuit board 300 may be made similar. Owing to this fact, it is possible to prevent a crack likely to occur at the interface of conductive materials due to a difference in coefficient of thermal expansion, and eventually, it is possible to overcome the problem of a poor contact (e.g., a short circuit) between the light emitting device 100 and the circuit board 300.

For example, according to the embodiment of the present disclosure, the support substrate 110 may be implemented with a ceramic material including AlN as described above, and the coefficient of thermal expansion (CTE) of the ceramic material is about 4.6 [ppm/°C]. The electrode pad 140 may be implemented with a copper (Cu) material, the coefficient of thermal expansion (CTE) of the copper material is about 16.5 [ppm/°C] larger than the ceramic material. The conductive bonding material 200 may be implemented with an Ag paste material, and the coefficient of thermal expansion (CTE) of the Ag paste material may be about 20 [ppm/°C] larger than the coefficient of thermal expansion (CTE) of the copper material.

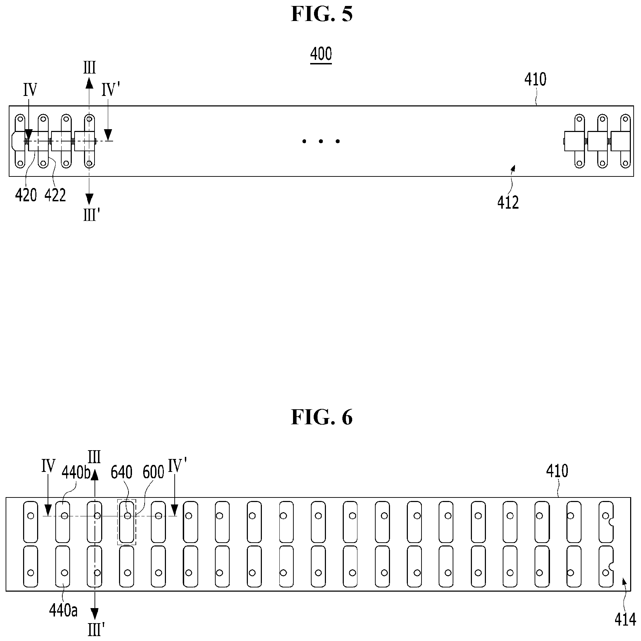

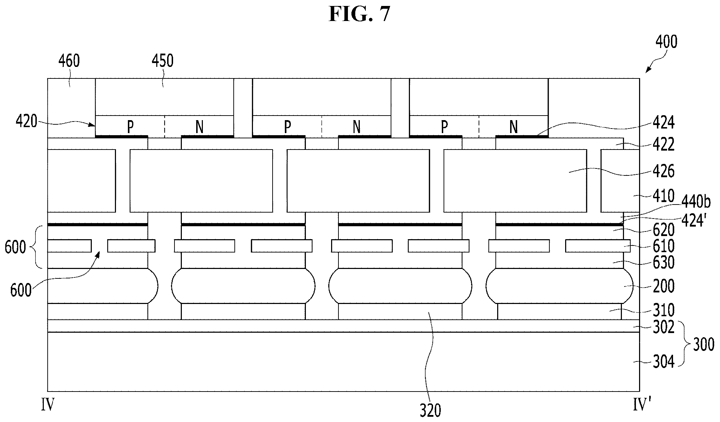

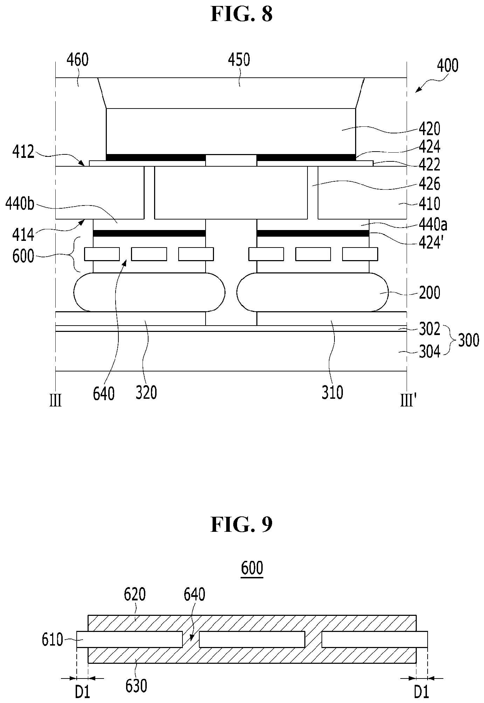

A light emitting device in accordance with another embodiment of the present disclosure is characterized in that a thermal expansion compensation layer (600 of FIGS. 7 and 8) is additionally formed on the lower surface of an electrode pad. Through this, it is possible to prevent a crack likely to occur due to differences in coefficient of thermal expansion among the electrode pad, a circuit pattern formed on one surface of a circuit board and a conductive bonding material formed between the electrode pad and the circuit pattern according to heat generation of a light emitting diode chip mounted in the light emitting device, and through this, it is possible to overcome the problem of a driving failure of the light emitting device. Such a light emitting device and a light emitting module including the same in accordance with the other embodiment of the present disclosure will be described below in more detail with reference to FIGS. 5 to 10.

FIG. 5 is a top view of a light emitting device in accordance with another embodiment of the present disclosure, and FIG. 6 is a bottom view of the light emitting device illustrated in FIG. 5. FIG. 7 is a cross-sectional view of a region IV-IV' of the light emitting device illustrated in FIGS. 5 and 6 and a light emitting module including the same, and FIG. 8 is a cross-sectional view of the light emitting device illustrated in FIGS. 5 and 6 and the light emitting module including the same, illustrating the cross-section of a specified region III-III'.

Referring to FIGS. 5 to 8, a light emitting device 400 in accordance with another embodiment of the present disclosure may include at least one light emitting diode chip 420 which is formed on a first surface 412 of a support substrate 410 having a white color, a wavelength conversion member 450 which is formed on a light emitting surface of the light emitting diode chip 420, a reflection member 460 which is formed to surround the side surface of the wavelength conversion member 450, and at least one of first and second electrode pads 440a and 440b, which is formed on a second surface 414 of the support substrate 410 and is electrically connected with the electrode of the light emitting diode chip 420.

Namely, when compared to the light emitting device 100 illustrated in FIGS. 1 to 4, the light emitting device 400 illustrated in FIGS. 5 to 8 has a difference in that not one electrode pad but a pair of electrode pads which are formed on the second surface 414 of the support substrate 410 to correspond to each light emitting diode chip 420 formed on the first surface 412 of the support substrate 410 are implemented.

For example, in the light emitting device 100 illustrated in FIGS. 1 to 4, the electrode pad 140 and the light emitting diode chip 120 correspond one to one. Thus, when the number of light emitting diode chips 120 is n, and electrode pads 140 corresponding thereto may also be implemented to have the number of n. That is to say, one electrode pad 140 may be electrically connected with one light emitting diode chip 120 corresponding thereto.

On the other hand, in the light emitting device 400 illustrated in FIGS. 5 to 8, the first and second electrode pads 440a and 440b and the light emitting diode chip 420 correspond two to one. Thus, when the number of light emitting diode chips 420 is n, the first and second electrode pads 440a and 440b corresponding thereto may be implemented to have the number of 2n. That is to say, the pair of first and second electrode pads 440a and 440b may be electrically connected with an electrode 422 which is connected to one light emitting diode chip 420 corresponding to the pair of first and second electrode pads 440a and 440b. In other words, the pair of first and second electrode pads 440a and 440b are pads through which currents of the same polarity flow. Because two electrode pads 440a and 440b of the same polarity are connected to one light emitting diode chip 420, even when a poor contact occurs in one of the two electrode pads 440a and 440b due to a crack or the like, normal driving may be possible since the other of the two electrode pads 440a and 440b is connected to the electrode 422 of the light emitting diode chip 420.

In the light emitting device 400 illustrated in FIGS. 5 to 8, when compared to the light emitting device 100 illustrated in FIGS. 1 to 4, the pair of first and second electrode pads 440a and 440b may simultaneously serve not only as electrode pads but also as heat sinks, and thus, the heat dissipation member 130 or 132 which is formed on the second surface 114 of the support substrate 110 may be removed.

Referring to FIG. 6, the first and second electrode pads 440a and 440b may be formed on the second surface 414 of the support substrate 410 to be vertically or horizontally symmetrical to each other.

Other components of the light emitting device 400 illustrated in FIGS. 5 to 8 may be substantially the same as other components of the light emitting device 100 illustrated in FIGS. 1 to 4. For example, the support substrate 410 may be implemented with a ceramic material including AlN, and due to this fact, the reflection of light generated from the light emitting diode chip 420 is possible, whereby light extraction efficiency may be improved.

Referring to FIGS. 7 and 8, the wavelength conversion member 450 converts the wavelength of light which is emitted from the light emitting diode chip 420, so that white light or light of a specific color is emitted. The wavelength conversion member 450 may be formed as a wavelength conversion material which converts the wavelength of light is mixed to a transparent resin such as silicon or epoxy, glass, ceramic, or the like.

The reflection member 460 may be formed to surround the side surface of the wavelength conversion member 450, and may perform an operation of reflecting light emitted from the light emitting diode chip 420. The reflection member 460 may be formed of at least one of silver (Ag) and aluminum (Al). As another embodiment, the reflection member 460 may be implemented with, for example, a silicon material having a white color.

As illustrated in FIGS. 5 and 7, the light emitting diode chip 420 may be implemented by a semiconductor PN junction diode, and a predetermined voltage may be applied through the electrode 422 which is attached to the lower surface of the light emitting diode chip 420. In the case of the embodiment illustrated in FIG. 7, light emitting diode chips 420 may be connected in series, and accordingly, each of the plurality of light emitting diode chips 420 may be formed to share the electrode 422 with an adjacent light emitting diode chip 420. A conductive adhesive layer 424 may be formed between the light emitting diode chip 420 and the electrode 422.

Referring to FIGS. 7 and 8 again, as the light emitting device 400 is mounted on a circuit board 300, a light emitting module which emits at least one light may be implemented. The circuit board 300 may be formed by, for example, a conductive substrate 304 which is implemented with aluminum or the like and an insulating buffer layer 302 which is formed on the conductive substrate 304.

In more detail, the electrode 422 which is electrically connected with the light emitting diode chip 420 is brought into electrical contact with the electrode pad 440, which is formed on the second surface 414 of the support substrate 410, through a via hole 426 which is formed in the support substrate 410.

In this case, when the light emitting device 400 is mounted on the circuit board 300, the first and second electrode pads 440a and 440b formed on the second surface 414 of the support substrate 410 and a circuit pattern 310 formed on a first surface of the circuit board 300 should be electrically connected. To this end, a conductive bonding material 200 is formed between the first and second electrode pads 440a and 440b and the circuit pattern 310.

The conductive bonding material 200 may be, for example, one of a solder paste including at least one of Sn, Pb, Cu, Ag, Au, Zn, Al, Bi and In, an Ag paste and an Si paste.

When compared to the light emitting module illustrated in FIG. 4, the light emitting module according to the embodiment illustrated in FIG. 8 is characterized in that a thermal expansion compensation layer 600 is additionally formed between the electrode pads 440a and 440b and the conductive bonding material 200. In other words, by additionally forming the thermal expansion compensation layer 600 on the lower surfaces of the electrode pads 440a and 440b, it is possible to prevent a crack likely to occur due to differences in coefficient of thermal expansion among the electrode pads 440a and 440b, the circuit pattern 310 formed on one surface of the circuit board 300 and the conductive bonding material 200 formed between the electrode pads 440a and 440b and the circuit pattern 310 according to heat generation of the light emitting diode chip 420 mounted in the light emitting device 400, and through this, it is possible to overcome the problem of a driving failure of the light emitting device 400.

FIG. 9 is an enlarged cross-sectional view of a thermal expansion compensation layer illustrated in FIG. 8.

Referring to FIG. 9, the thermal expansion compensation layer 600 includes an insulating layer 610 which has at least one via hole 640, a first conductive layer 620 which is formed on a first surface of the insulating layer 610 and a second conductive layer 630 which is formed on a second surface of the insulating layer 610. The first conductive layer 620 and the second conductive layer 630 are electrically connected through the via hole 640. When the via hole 640 is implemented as one, the position thereof may be defined in a center region or may be defined to be deviated to the outside.

The insulating layer 610 performs an operation of compensating for differences in degree of expansion according to the degrees of heat absorption of conductive materials positioned between the support substrate 410 and the circuit board 300 (e. g., the electrode pads 440a and 440b, the conductive bonding material 200 and the circuit pattern 310). The insulating layer 610 may be implemented with a material having a relatively small coefficient of thermal expansion compared to the conductive materials. For example, the insulating layer 610 may be formed of a polyimide (PI) material. Namely, as illustrated in FIG. 9, the insulating layer 610 which is formed of a polyimide material is structured to have a shape which surrounds the first conductive layer 620 and the second conductive layer 630, and through this, may serve to suppress the expansion of the first and second conductive layers 620 and 630 by heat. However, this is nothing but a mere example, and the thermal expansion compensation layer 600 according to the present disclosure is not limited thereto.

The first conductive layer 620 which is formed on the first surface of the insulating layer 610 is a portion which is brought into contact with and is thus electrically connected with the first and second electrode pads 440a and 440b. Therefore, the first conductive layer 620 may be implemented with the same material as the first and second electrode pads 440a and 440b. As illustrated in FIG. 8, the first conductive layer 620 may be implemented as a pattern having the same width and shape as those of the first and second electrode pads 440a and 440b brought into contact therewith.

The second conductive layer 630 which is formed on the second surface of the insulating layer 610 is connected with the first conductive layer 620 through the via hole 640 which is formed in the insulating layer 610. In the same manner as the first conductive layer 620, the second conductive layer 630 may also be implemented with the same material as the first and second electrode pads 440a and 440b. Therefore, as illustrated in FIG. 8, the second conductive layer 630 may also be implemented as a pattern having the same width and shape as those of the first conductive layer 620.

For example, the first conductive layer 620 and the second conductive layer 630 may be formed by applying a conductive material the same as that of the electrode pads 440a and 440b on the pattern of the insulating layer 610 in which the via hole 640 is formed and by then using an electrolytic plating method. Through this, the pattern of the thermal expansion compensation layer 600 having a shape corresponding to each of the electrode pads 440a and 440b may be formed.

That is to say, each pattern of the thermal expansion compensation layer 600 according to the embodiment of the present disclosure may correspond to each of the first and second electrode pads 440a and 440b illustrated in FIG. 5. Thus, the patterns of the thermal expansion compensation layer 600 may be formed to be symmetrical to each other in the same manner as the first and second electrode pads 440a and 440b.

In addition, in the case of the embodiment of the present disclosure, the insulating layer 610 of the thermal expansion compensation layer 600 is characterized in that it is implemented in a shape protruding by a predetermined distance D1 out of the first and second conductive layers 620 and 630 when viewed on a cross-section. Through this, it is possible to compensate for differences more efficiently in degree of expansion according to the degrees of heat absorption of conductive materials positioned between the support substrate 410 and the circuit board 300 (e.g., the electrode pads 440a and 440b, the conductive bonding material 200 and the circuit pattern 310).

An embodiment of schematic thicknesses and/or materials of respective components of the light emitting module in accordance with the embodiment of the present disclosure may be described with reference to FIGS. 8 and 9 as follows.

As illustrated in FIG. 8, the light emitting module may be formed as a stack structure of the circuit board 300, the circuit pattern 310, the conductive bonding material 200, the thermal expansion compensation layer 600, a conductive adhesive layer 424', the electrode pads 440a and 440b, the support substrate 410, the electrode 422, the conductive adhesive layer 424, the light emitting diode chip 420 and the wavelength conversion member 450.

The circuit board 300 may be formed by the conductive substrate 304 of an aluminum material having a thickness of about 1500 um and the insulating buffer layer 302 having a thickness of about 40 um.

Each of the circuit pattern 310, the electrode pads 440a and 440b and the electrode 422 may be implemented with a Cu material having a thickness of about 50 um, the conductive adhesive layers 424 and 424' may be implemented with an AuSn material having a thickness of about 5 um, and the support substrate 410 may be implemented with a ceramic material including AlN and having a thickness of about 380 um.

Each of the wavelength conversion member 450 and the light emitting diode chip 420 may be formed to a thickness of about 150 um.

The thermal expansion compensation layer 600 may include the first and second conductive layers 620 and 630 each of which is implemented with a Cu material having a thickness of about 50 um and the insulating layer 610 which is implemented with a polyimide material having a thickness of about 25 um.

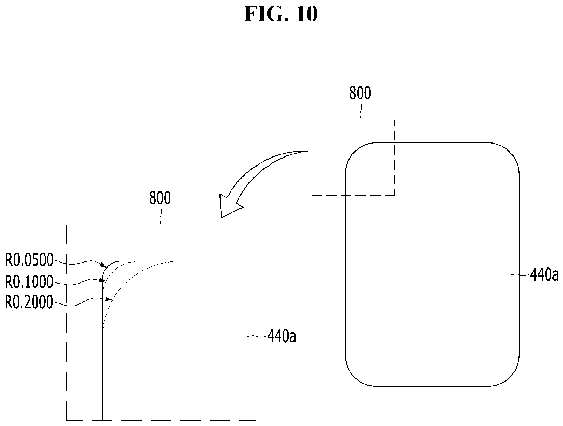

FIG. 10 is an enlarged top view of a first electrode pad illustrated in FIG. 5.

For the sake of convenience in explanation, FIG. 10 illustrates the first electrode pad 440a, but the second electrode pad 440b may also be implemented in the same shape as the first electrode pad 440a.

Referring to FIG. 10, the electrode pad 440a in accordance with the embodiment of the present disclosure is characterized in that a corner portion 800 is implemented in a pattern shape having a predetermined curvature. As the corner portion 800 of the electrode pad 440a is implemented in a curve shape, it is possible to prevent a stress from being concentrated on a corner. Accordingly, a stress due to differences in coefficient of thermal expansion among the electrode pads 440a and 440b, the circuit pattern 310 and the conductive bonding material 200 according to heat generation of the light emitting diode chip 420 may be distributed, and through this, It is possible to prevent cracks in the components.

FIG. 10 illustrates, as an example, the electrode pad 440a in which a radius of curvature R of the corner portion 800 is 0.05, but a radius of curvature is not limited thereto. As another embodiment, the radius of curvature R may be implemented as 0.1 or 0.2.

Although certain exemplary embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

Accordingly, the spirit of the present invention should not be limited to the described embodiments, and the scope of claims described below as well as all modifications that are equivalent or equivalent to the scope of the claims shall fall within the scope of the spirit of the present invention.

### [Industrial Applicability]

According to the embodiments, by forming a thermal expansion compensation layer on the lower surface of an electrode pad of a light emitting device, it is possible to prevent a crack due to differences in coefficient of thermal expansion among the electrode pad, a circuit pattern formed on one surface of a circuit board and a conductive bonding material formed between the electrode pad and the circuit pattern according to heat generation of a light emitting diode chip mounted in the light emitting device, and through this, overcome the problem of a driving failure of the light emitting device.

## Claims

1. A light emitting device comprising:
a support substrate;
a light emitting diode chip mounted on a first surface of the support substrate;
a wavelength conversion member formed on a light emitting surface of the light emitting diode chip, and a reflection member formed to surround a side surface of the wavelength conversion member;
an electrode pad formed on a second surface of the support substrate to be electrically connected with the light emitting diode chip;
a conductive bonding material formed on one surface of the electrode pad; and
a thermal expansion compensation layer formed on one surface of the conductive bonding material,
wherein the thermal expansion compensation layer includes a conductive layer and an insulating layer, and at least a portion of the insulating layer is formed between portions of the conductive layer, and
wherein a portion of the conductive layer is surrounded by the insulating layer.

2. The light emitting device according to claim 1, wherein the support substrate is implemented with a ceramic material including AlN, and the reflection member is implemented with a silicon material having a white color.

3. The light emitting device according to claim 1, further comprising:
a heat dissipation member formed on the second surface of the support substrate to be spaced apart from the electrode pad by a predetermined distance.

4. The light emitting device according to claim 3, wherein the heat dissipation member is implemented in an integral plate shape or is implemented as honeycomb-shaped separate patterns.

5. The light emitting device according to claim 1, wherein the electrode pad includes a pair of first and second electrode pads which are electrically connected with the light emitting diode chip corresponding to the electrode pad.

6. The light emitting device according to claim 5, wherein the first and second electrode pads are pads of the same polarity, and are formed on the second surface of the support substrate to be vertically or horizontally symmetrical to each other.

7. The light emitting device according to claim 1, wherein the electrode pad is implemented in a pattern shape in which a corner portion has a predetermined curvature.

8. The light emitting device according to claim 1, wherein
the thermal expansion compensation layer is formed between the electrode pad and the conductive bonding material, and
the thermal expansion compensation layer includes the insulating layer which has at least one via hole, a first conductive layer which is formed on a first surface of the insulating layer and a second conductive layer which is formed on a second surface of the insulating layer, and the first conductive layer and the second conductive layer are electrically connected through the via hole.

9. The light emitting device according to claim 8, wherein the insulating layer is implemented with a polyimide material whose coefficient of thermal expansion is relatively small as compared to the electrode pad and conductive bonding material.

10. The light emitting device according to claim 8, wherein the first conductive layer and the second conductive layer are implemented with the same material as the electrode pad, and each is implemented in a pattern shape which has the same width and shape as the electrode pad.

11. The light emitting device according to claim 8, wherein the insulating layer is implemented in a pattern of a shape which protrudes by a predetermined distance out of the first conductive layer and the second conductive layer when viewed on a cross-section.

12. A light emitting module comprising:
a light emitting diode chip mounted on a first surface of a support substrate;
a wavelength conversion member formed on a light emitting surface of the light emitting diode chip, and a reflection member formed to surround a side surface of the wavelength conversion member;
an electrode pad formed on a second surface of the support substrate to be electrically connected with the light emitting diode chip;
a circuit board formed with a circuit pattern which is electrically connected with the electrode pad; and
a conductive bonding material formed between the electrode pad and the circuit pattern to electrically connect the electrode pad and the circuit pattern,
wherein coefficients of thermal expansion of the support substrate, the electrode pad and the conductive bonding material are different, and a coefficient of thermal expansion gradually increases from the support substrate to the circuit board.

13. The light emitting module according to claim 12, wherein the support substrate is implemented with a ceramic material including AlN, and the reflection member is implemented with a silicon material having a white color.

14. The light emitting module according to claim 12, wherein the electrode pad includes a pair of first and second electrode pads which are electrically connected with the light emitting diode chip corresponding to the electrode pad.

15. The light emitting module according to claim 12, wherein the first and second electrode pads are pads of the same polarity, and are formed on the second surface of the support substrate to be vertically or horizontally symmetrical to each other.

16. The light emitting module according to claim 12, wherein the electrode pad is implemented in a pattern shape in which a corner portion has a predetermined curvature.

17. The light emitting module according to claim 12, wherein
a thermal expansion compensation layer is additionally included between the electrode pad and the conductive bonding material, and
the thermal expansion compensation layer includes an insulating layer which has at least one via hole, a first conductive layer which is formed on a first surface of the insulating layer and a second conductive layer which is formed on a second surface of the insulating layer, and the first conductive layer and the second conductive layer are electrically connected through the via hole.

18. The light emitting module according to claim 17, wherein the insulating layer is implemented with a polyimide material whose coefficient of thermal expansion is relatively small as compared to the electrode pad and conductive bonding material.

19. The light emitting module according to claim 17, wherein the first conductive layer and the second conductive layer are implemented with the same material as the electrode pad, and each is implemented in a pattern shape which has the same width and shape as the electrode pad.

20. The light emitting module according to claim 18, wherein the insulating layer is implemented in a pattern of a shape which protrudes by a predetermined distance out of the first conductive layer and the second conductive layer when viewed on a cross-section.
